# FASCICULE DE BREVET EUROPEEN

(11) **EP 3 999 942 B1**
(45) Date de publication et mention de la délivrance du brevet: **30.08.2023**
(21) Numéro de dépôt: 20740010.2
(22) Date de dépôt: 16.07.2020
(51) Int. Cl.: G06F 3/0354, G06F 3/0338, G06F 3/0362, G06F 3/0481, G01R 33/00, G01V 3/08, A63H 27/14, A63H 33/18, F41B 3/03, A63F 13/21, A63F 13/573, F41B 3/02

(54) **PROCÉDÉ DE COMMANDE D'UNE INTERFACE GRAPHIQUE POUR AFFICHER LE LANCER D'UN PROJECTILE DANS UN ENVIRONNEMENT VIRTUEL**
VERFAHREN ZUR STEUERUNG EINER GRAFISCHEN SCHNITTSTELLE ZUR ANZEIGE DES ABSCHUSSES EINES PROJEKTILS IN EINER VIRTUELLEN UMGEBUNG
METHOD FOR CONTROLLING A GRAPHIC INTERFACE FOR DISPLAYING THE LAUNCHING OF A PROJECTILE IN A VIRTUAL ENVIRONMENT

(30) Priorité: 19.07.2019 FR 1908213
(43) Date de publication de la demande: 25.05.2022
(73) Titulaire: Advanced Magnetic Interaction, AMI, 38170 Seyssinet-Pariset (FR)
(72) Inventeur: BONNEAU, Sophie, 38400 SAINT-MARTIN-D'HÈRES (FR); CHESNEY, Romain, 38400 SAINT-MARTIN-D'HÈRES (FR); DUPRÉ LA TOUR, Jean-Marie, 38400 SAINT-MARTIN-D'HÈRES (FR); HAUTSON, Tristan, 38400 SAINT-MARTIN-D'HÈRES (FR); MANCHOUL, Ons, 38400 SAINT-MARTIN-D'HÈRES (FR); THOMAS, Simon, 38400 SAINT-MARTIN-D'HÈRES (FR); TRAVEAUX, Jean-Pierre, 38400 SAINT-MARTIN-D'HÈRES (FR)
(74) Mandataire: Peterreins Schley
(86) Numéro de dépôt international: PCT/EP2020/070100
(87) Numéro de publication internationale: WO 2021/013676

(56) Documents cités:
- WO-A1-2014/180797
- WO-A1-2017/141189
- US-A- 6 102 405
- US-A1- 2013 303 247
- US-A1- 2015 375 128
- US-A1- 2018 065 058

## Description

### DOMAINE TECHNIQUE

L'invention porte sur un procédé et un appareil de commande d'une interface graphique pour afficher des images d'un objet tridimensionnel, ici un lanceur, dans un environnement virtuel prédéfini.

### ÉTAT DE LA TECHNIQUE ANTÉRIEURE

Il existe des appareils et des procédés de commande d'une interface graphique pour afficher des images d'un objet tridimensionnel virtuel, par exemple d'un bâtiment ou un véhicule, voire une ville. Cet objet tridimensionnel virtuel peut former un « environnement virtuel » à afficher sur l'interface graphique, en particulier lorsqu'il s'agit d'une ville ou d'un quartier.

Pour cela, l'objet tridimensionnel virtuel est codé dans un fichier numérique, et un procédé de commande peut permettre d'afficher une image de l'objet tridimensionnel virtuel sur une interface graphique tel qu'un écran d'un ordinateur ou d'une tablette électronique. Le fichier numérique comporte alors les positions de tous les points de l'objet tridimensionnel virtuel dans un repère dit virtuel à trois dimensions.

Le brevet EP2994813 B1 (issu de la demande WO 2014/180797 A1) décrit un exemple d'appareil et de procédé de commande d'une interface graphique pour afficher des images d'un objet tridimensionnel virtuel. Il comporte un pointeur équipé d'un aimant pouvant être manipulé par un utilisateur dans une zone de suivi. La localisation du pointeur est assurée par un dispositif de localisation comportant un réseau de magnétomètres. Le déplacement du pointeur dans la zone de suivi permet alors de déterminer l'axe optique du champ de vue de l'objet tridimensionnel virtuel ainsi qu'un coefficient d'échelle lorsque le pointeur se rapproche ou s'éloigne de l'objet tridimensionnel virtuel.

Cependant, il existe un besoin de disposer d'un appareil et d'un procédé de commande d'une interface graphique permettant d'interagir de manière dynamique avec l'environnement virtuel représenté sur les images affichées.

On connaît par ailleurs, dans ce domaine technique, les documents US 2015/375128 A1, WO 2017/141189 A1, US 2018/065058 A1, US 6 102 405 A, et US 2013/303247 A1.

### EXPOSÉ DE L'INVENTION

L'invention a pour objectif de remédier au moins en partie aux inconvénients de l'art antérieur, et plus particulièrement de proposer un procédé de commande d'une interface graphique permettant à un utilisateur d'interagir de manière dynamique avec l'environnement virtuel, à l'aide d'un objet tridimensionnel réel (c'est-à-dire physique, non numérique) manipulable par l'utilisateur, et plus précisément ici de procéder au lancer d'un projectile dans l'environnement virtuel suivant une trajectoire définie par l'utilisateur.

Pour cela, l'objet de l'invention est un procédé de commande d'une interface graphique pour afficher des images d'une représentation numérique d'un objet tridimensionnel, appelé lanceur, dans un environnement virtuel, le lanceur étant adapté à lancer un projectile dans un environnement virtuel, et comportant une structure réalisée en un matériau non magnétique à laquelle est assemblé un bras de lancement de manière mobile et contrainte en déplacement, un aimant étant fixé au bras de lancement.

Le procédé est mis en oeuvre par une unité de calcul, et comporte les étapes suivantes :
- fourniture d'un dispositif de localisation du lanceur dans une zone de suivi, comportant : un réseau de magnétomètres fixés à une surface d'appui ; l'unité de calcul étant connectée au réseau de magnétomètres et à l'interface graphique ; la zone de suivi du lanceur par rapport au réseau de magnétomètres étant prédéfinie, et un repère tridimensionnel dit réel étant associé à la zone de suivi ;
- enregistrement dans l'unité de calcul : d'un fichier numérique codant l'environnement virtuel dans un repère tridimensionnel dit virtuel, le repère virtuel étant associé au repère réel par une relation de correspondance prédéfinie ; et d'un modèle numérique permettant d'associer, à un vecteur d'état X_{a|r} de l'aimant représentatif de la position et de l'orientation de l'aimant dans le repère réel, un vecteur d'état X_{b,v} du bras de lancement représentatif de la position et/ou de l'orientation du bras de lancement dans le repère virtuel, et permettant d'obtenir une représentation numérique du lanceur dans le repère virtuel ;
- manipulation, par un utilisateur, du bras de lancement, le lanceur étant situé dans la zone de suivi et disposé au contact de la surface d'appui, le bras de lancement étant susceptible d'être écarté d'une position de repos par l'utilisateur, un organe de rappel exerçant alors une force de rappel sur le bras de lancement en direction de la position de repos ;
- mesure, par le réseau de magnétomètres, d'un champ magnétique généré par l'aimant à différents instants de mesure tₙ successifs ;
- détermination du vecteur d'état X_{a|r} de l'aimant dans le repère réel, à l'instant de mesure tₙ, à partir des mesures du champ magnétique généré par l'aimant ;
- détermination du vecteur d'état X_{b|v} du bras de lancement dans le repère virtuel, ainsi que de la position P_{p|v} du projectile, à partir du modèle numérique préenregistré et du vecteur d'état X_{a|r} prédéterminé, à l'instant de mesure tₙ;
- identification d'une phase d'armement du bras de lancement, en fonction d'un facteur K1 dit d'armement défini à partir du vecteur d'état X_{b|v} à l'instant de mesure tₙ et à des instants de mesure antérieurs, la phase d'armement étant identifiée lorsque le facteur d'armement K1 est supérieur ou égal à une valeur seuil K1s prédéfinie ;
- lorsque la phase d'armement est identifiée, identification du tir du projectile en fonction d'un facteur K2 dit de lancement défini à partir du vecteur d'état X_{b|v} à l'instant de mesure tₙ, le tir du projectile étant identifiée lorsque le facteur de lancement K2 est supérieur ou égal à une valeur seuil K2s prédéfinie ;
- lorsque le tir du projectile est identifié, détermination des positions successives P_{p|v} du projectile dans le repère virtuel à des instants de mesure ultérieurs ;
- construction d'une image bidimensionnelle, représentant dans le repère virtuel l'environnement virtuel, la représentation numérique du lanceur, ainsi que le projectile, à partir du vecteur d'état X_{b|v} du bras de lancement et de la position P_{p|v} du projectile prédéterminés, puis commande de l'interface graphique par l'unité de calcul pour afficher l'image construite.

Certains aspects préférés mais non limitatifs de ce procédé de commande sont les suivants.

Le modèle numérique peut permettre également d'associer, au vecteur d'état X_{a|r} de l'aimant, un vecteur d'état X_{l,v} du lanceur représentatif de la position et de l'orientation du lanceur dans le repère virtuel. Auquel cas : lors de l'étape de manipulation, l'utilisateur peut alors manipuler également le lanceur ; lors de l'étape de détermination du vecteur d'état X_{b|v} du bras de lancement, le vecteur d'état X_{l,v} du lanceur peut également être déterminé à partir du modèle numérique préenregistré et du vecteur d'état X_{a|r} prédéterminé ; lors de l'étape de construction, l'image bidimensionnelle peut alors afficher la représentation numérique du lanceur à partir du vecteur d'état X_{l|v} du lanceur.

L'étape de détermination des positions successives P_{p|v} du projectile peut comporter une identification d'une intersection entre l'une des positions successives P_{p|v} déterminées et une surface de l'environnement virtuel, ladite intersection étant alors représentative d'un impact du projectile, et détermination d'un temps de vol entre l'instant de mesure auquel le tir du projectile est identifié et l'instant de mesure correspondant audit impact.

Au cours des instants de mesure appartenant audit temps de vol, les étapes d'identification d'une phase d'armement, d'identification du tir du projectile, et de détermination des positions successives P_{p|v} du projectile, peuvent ne pas être effectuées.

Le facteur d'armement K1 peut être défini à partir d'un angle d'inclinaison de l'aimant lorsque le bras de lancement est assemblé par liaison pivot sur la structure et/ou d'une position suivant un axe orthogonal à la surface d'appui, et/ou d'une position suivant un plan parallèle à la surface d'appui.

La phase d'armement peut être identifiée pour tout instant de mesure dit courant tₙ ultérieur à un instant de mesure de référence t_{ref} pour lequel le bras de lancement a présenté un facteur d'armement K1(t_{ref}) supérieur ou égal à la valeur seuil prédéfinie K1s, le bras de lancement à l'instant de mesure courant tₙ étant alors distant de la position de repos.

Lorsque la phase d'armement est identifiée, une trajectoire estimée du projectile dans le repère virtuel peut être déterminée sur la base du vecteur d'état X_{l|v} du lanceur et du vecteur d'état X_{b|v} du bras de lancement, et une représentation numérique de la trajectoire estimée peut être affichée sur l'image construite lors de l'étape de commande de l'interface graphique.

Le tir du projectile peut être identifié à un instant de mesure pour lequel le bras de lancement atteint sa position de repos, la phase d'armement étant identifié à au moins l'instant de mesure précédent.

Le facteur de lancement K2 peut être défini à partir d'une vitesse moyenne et/ou d'une vitesse instantanée du bras de lancement à au moins l'instant de mesure pour lequel il atteint sa position de repos.

Le vecteur d'état X_{a|r} de l'aimant peut être déterminé par un algorithme d'estimation bayésien ou par une méthode d'optimisation.

L'environnement virtuel peut être un espace tridimensionnel de dimensions supérieures à celles de la zone de suivi.

L'invention porte également sur un support d'enregistrement d'informations, comportant des instructions pour l'exécution d'un procédé de commande selon l'une quelconque des caractéristiques précédentes, lorsque ces instructions sont exécutées par une unité de calcul électronique.

L'invention porte également sur un appareil de commande d'une interface graphique pour afficher des images d'une représentation numérique d'un objet tridimensionnel appelé lanceur, dans un environnement virtuel, adapté à la mise en oeuvre du procédé de commande selon l'une quelconque des caractéristiques précédentes, comportant :
- un lanceur comportant une structure réalisée en un matériau non magnétique à laquelle est assemblé un bras de lancement de manière mobile et contrainte en déplacement, un aimant étant fixé au bras de lancement ;
- une interface graphique ;
- un dispositif de localisation comportant :
   ∘ un réseau de magnétomètres fixés à une surface d'appui ;
   ∘ une unité de calcul comportant une mémoire dans laquelle est enregistrée un fichier numérique codant l'environnement virtuel dans un repère virtuel, ainsi qu'un modèle numérique du lanceur et du bras de lancement, l'unité de calcul étant programmée pour :
      ▪ acquérir des mesures du champ magnétique généré par l'aimant ;
      ▪ calculer un vecteur d'état X_{a|r} de l'aimant dans un repère réel associé à une zone de suivi défini par rapport à la surface d'appui ;
      ▪ déterminer un vecteur d'état X_{l|v} du lanceur dans le repère virtuel, un vecteur d'état X_{b|v} du bras de lancement dans le repère virtuel, et la position P_{p|v} du projectile dans le repère virtuel ;
      ▪ identification d'une phase d'armement, et le cas échéant, identification d'un tir du projectile et détermination des positions successives P_{p|v} du projectile dans le repère virtuel à différents instants ;
      ▪ construire une image bidimensionnelle représentant l'environnement virtuel, une représentation numérique du lanceur et le projectile dans le repère virtuel ;
      ▪ commander l'interface graphique pour afficher l'image construite.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B sont des vues schématiques et partielles, en coupe, d'un appareil de commande d'une interface graphique selon un mode de réalisation ;
les figures 2A et 2B sont des vues schématiques et partielles, en perspective, d'une zone de suivi associé à un repère tridimensionnel réel (fig.2A) et d'un environnement virtuel associé à un repère tridimensionnel virtuel (fig.2B) ;
la figure 3 est une vue schématique d'une interface graphique affichant, dans l'environnement virtuel, une représentation numérique d'un lanceur de l'appareil de commande ;
la figure 4 est un exemple d'évolution temporelle de l'angle d'inclinaison que forme l'aimant fixé au bras de commande du lanceur lors de sa manipulation par un utilisateur ;
la figure 5 est un organigramme illustrant des étapes d'un procédé de commande d'une interface graphique selon un mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de commande d'une interface graphique pour afficher des images d'une représentation numérique d'un objet tridimensionnel réel dans un environnement virtuel, et d'effectuer, dans l'environnement virtuel, une action déterminée de manière dynamique par l'utilisateur à l'aide de l'objet tridimensionnel réel.

Selon l'invention, l'objet tridimensionnel réel est un objet appelé lanceur adapté à lancer un projectile dans l'environnement virtuel, c'est-à-dire un projectile virtuel. Le lanceur comporte une structure et un bras de lancement monté mobile en déplacement sur la structure. Un aimant est fixé sans degré de liberté au bras de lancement. Le lanceur peut être une catapulte, un canon, ou tout autre objet pouvant procéder au lancement d'un projectile. Le lanceur est adapté à reposer au contact d'une surface d'appui en vue de procéder au lancement du projectile.

Le procédé de commande met en oeuvre le suivi de l'aimant par un dispositif de localisation comportant un réseau de magnétomètres lorsque le lanceur est manipulé par un utilisateur. L'aimant évolue alors dans une zone de suivi associée au réseau de magnétomètres. Autrement dit, le dispositif de localisation estime la position et l'orientation de l'aimant dans un repère tridimensionnel réel associé à la zone de suivi aux différents instants de mesure successifs.

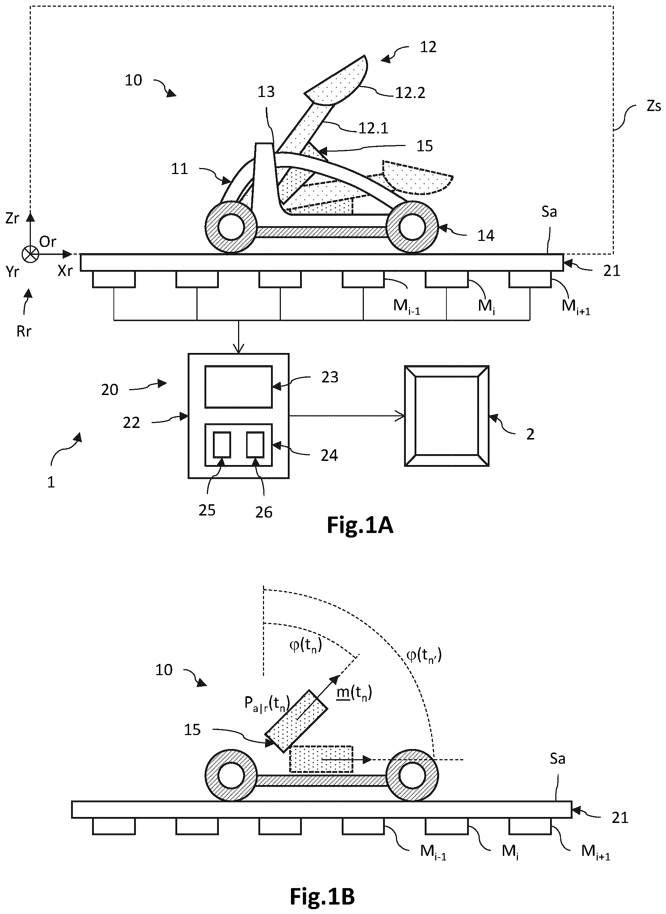

Les figures 1A et 1B sont des vues schématiques et partielles d'un appareil de commande 1 d'une interface graphique 2 pour afficher des images d'une représentation numérique 31 d'un lanceur 10 et d'un projectile 32 dans l'environnement virtuel Ev, et effectuer une action de lancer du projectile 32 dans l'environnement virtuel Ev à l'aide du lanceur 10. La fig.1B est une vue simplifiée de la fig.1A. L'appareil de commande 1 comporte un lanceur 10 muni d'un aimant 15, un dispositif de localisation 20 de l'aimant dans un repère réel Rr, et une interface graphique 2.

Le lanceur 10 est un objet tridimensionnel physique (i.e. réel, non numérique) destiné à être manipulé par un utilisateur, par exemple à la main, pour lancer un projectile 32 dans un environnement virtuel Ev. Dans cet exemple, il s'agit d'une catapulte, mais il peut s'agir d'un canon, d'un lance-pierre, d'une arbalète, ou de tout autre objet pouvant lancer un projectile.

Le lanceur 10 comporte une structure rigide 11 réalisée en un matériau non magnétique, par exemple du plastique, à laquelle est assemblé un bras de lancement 12 de manière mobile et contrainte en déplacement. La structure 11 comporte ici des roues 14 par lesquelles il peut reposer sur une surface d'appui Sa du dispositif de localisation 20.

Le bras de lancement 12 comporte une portion longitudinale 12.1 et une portion de support 12.2 d'un projectile 32. La portion longitudinale 12.1 s'étend suivant un axe longitudinal entre une première extrémité par laquelle elle est assemblée à la structure rigide 11, et une deuxième extrémité opposée à laquelle est fixée la portion de support 12.2. Le bras de lancement 12 est ici réalisé également en un matériau non magnétique.

Le bras de lancement 12 est assemblé de manière mobile en déplacement à la structure rigide 11, par exemple en rotation et/ou en translation. Dans cet exemple d'une catapulte, le bras de lancement 12 est assemblé par une liaison pivot. De plus, il est contraint en déplacement, et ici en rotation, par un organe de rappel (non représenté). L'organe de rappel peut être un ressort, de type ressort hélicoïdal ou ressort à lame. Dans le cas d'un canon, le bras de lancement 12 est mobile en translation vis-à-vis de la structure rigide 11.

Au repos, le bras de lancement 12 occupe une position de butée dans laquelle il est maintenu au contact d'une portion d'arrêt 13 de la structure rigide 11 par l'organe de rappel. En effet, l'organe de rappel exerce en continu une force de rappel sur le bras de lancement 12 en direction de la portion d'arrêt 13. Lorsque l'utilisateur actionne le bras de lancement 12, il écarte plus ou moins le bras de lancement 12 vis-à-vis de sa position de butée. Si l'utilisateur relâche le bras de lancement 12, l'organe de rappel le ramène d'autant plus rapidement qu'il était éloigné de sa position de butée. Dans cet exemple, le bras de lancement 12 occupe une position de butée (contact avec la portion d'arrêt 13), mais d'une manière générale, au repos, il occupe une position dite de repos dans laquelle il n'est pas nécessairement au contact d'une portion d'arrêt du lanceur 10, comme dans le cas d'un lance-pierre.

Le lanceur 10 comporte un objet magnétique 15, ici un aimant permanent, fixé sans degré de liberté au bras de lancement. L'objet magnétique 15 comporte un matériau présentant une aimantation, par exemple rémanente, pour lequel on définit un moment magnétique m. Il peut être un aimant permanent cylindrique, par exemple annulaire, tel qu'illustré dans le document WO2014/053526, voire un électroaimant.

Le matériau magnétique est de préférence ferrimagnétique ou ferromagnétique. Il présente un moment magnétique spontané non nul m même en l'absence d'un champ magnétique extérieur. Il peut présenter un champ magnétique coercitif supérieur à 100 A.m⁻¹ ou 500 A.m⁻¹ et l'intensité du moment magnétique m est de préférence supérieure à 0,01 A.m² voire à 0,1 A.m², par exemple égale à 0,8 A.m² environ. On considère que l'objet magnétique peut être approximé par un dipôle magnétique, mais d'autres modèles peuvent être utilisés. L'axe magnétique de l'objet magnétique est défini comme étant l'axe colinéaire au moment magnétique m de l'objet magnétique.

Comme l'illustre la fig.1B, lorsque le bras de lancement 12 occupe la position de butée, l'axe du moment magnétique m de l'aimant (noté également axe magnétique m) forme un angle d'inclinaison ϕ₀ de repos, cet angle étant défini par l'inclinaison de l'axe magnétique m par rapport à un axe vertical, orthogonal au plan passant par les roues du lanceur. A titre d'exemple, l'angle de repos ϕ₀ peut être égal à 45°. L'axe magnétique m de l'aimant peut être parallèle ou non à l'axe longitudinal du bras de lancement.

Lorsqu'un utilisateur actionne le bras de lancement 12, et donc écarte ce dernier vis-à-vis de la position de butée, l'angle d'inclinaison ϕ(t) devient supérieur à l'angle de repos ϕ₀. Cet angle d'inclinaison ϕ(t) peut varier entre l'angle de repos ϕ₀ et un angle d'inclinaison maximale ϕₘₐₓ.

Le dispositif de localisation 20 est adapté à localiser l'aimant 15 dans un repère tridimensionnel Rr dit réel, et plus précisément dans une zone de suivi Zs associé à un réseau de magnétomètres Mᵢ.

Par localiser, on entend déterminer la position et l'orientation de l'aimant 15 dans la zone de suivi Zs. La position P_{a|r} de l'aimant 15 correspond aux coordonnées du centre géométrique de l'aimant, c'est-à-dire au barycentre non pondéré de l'ensemble des points de l'aimant. Par ailleurs, le moment magnétique m de l'aimant 15 est un vecteur dont les composantes sont (mₓ, m_{y}, m_{z}) dans le repère réel Rr. Sa norme, également appelée intensité ou amplitude, est notée ∥m∥ ou m.

On définit ici et pour la suite de la description le repère tridimensionnel réel Rr, ici direct, (Or,Xr,Yr,Zr), où les axes Xr et Yr forment un plan parallèle à une surface d'appui Sa du dispositif de localisation 20, et où l'axe Zr est orienté de manière sensiblement orthogonale à la surface d'appui et opposée aux magnétomètres. Dans la suite de la description, les termes « vertical » et « verticalement » s'étendent comme étant relatifs à une orientation sensiblement parallèle à l'axe Zr, et les termes « horizontal » et « horizontalement » comme étant relatifs à une orientation sensiblement parallèle au plan (Xr,Yr). Par ailleurs, les termes « inférieur » et « supérieur » s'étendent comme étant relatifs à un positionnement croissant lorsqu'on s'éloigne de la surface d'appui Sa suivant la direction +Zr. Dans cet exemple, l'origine Or est situé en bordure de la zone de suivi Zs mais elle peut être située ailleurs dans la zone de suivi Zs, par exemple en bordure de la surface d'appui Sa.

L'aimant 15 est destiné à évoluer dans la zone de suivi Zs. Celle-ci est un espace dans lequel le rapport signal sur bruit SNR (pour *Signal to Noise Ratio*, en anglais) d'au moins l'un des magnétomètres du dispositif de localisation est supérieur ou égal à une valeur seuil prédéfinie. A titre d'exemple, la zone de suivi Zs peut être un espace dans lequel le signal, c'est-à-dire la norme ou au moins une composante du champ magnétique généré par l'aimant et mesuré par le magnétomètre correspondant, est supérieur ou égal à, par exemple, 20 fois le bruit. Le bruit associé à chaque magnétomètre peut être égal à 0,3µT environ. Dans ce cas, la zone de suivi Zs correspond à une zone de l'espace dans laquelle le champ magnétique généré par l'aimant 15 et mesuré par au moins l'un des magnétomètres Mᵢ est supérieur ou égal à 6µT environ, ce qui correspond à une distance dₘₐₓ égale à 20cm environ suivant l'axe directeur passant par le magnétomètre Mᵢ considéré. Plus simplement, la zone de suivi Zs peut être définie comme un espace dans lequel chaque point est à une distance inférieure ou égale à une distance maximale dₘₐₓ selon l'axe directeur passant par le magnétomètre Mᵢ le plus proche, celle-ci étant par exemple égale à 20cm, voire à 10cm, ou encore à 5cm.

Le dispositif de localisation 20 est apte à mesurer le champ magnétique ambiant, dont l'une des contributions est le champ magnétique généré par l'aimant 15, à différents instants de mesure, au cours d'une durée T de suivi, dans le repère réel Rr, et ensuite à estimer la position et l'orientation de l'aimant 15 sur la base des mesures des magnétomètres Mᵢ.

Pour cela, il comporte un réseau de magnétomètres Mᵢ répartis les uns vis-à-vis des autres de manière à former un plan de mesure. Ils sont fixés à une surface d'appui Sa sans degré de liberté. Le nombre de magnétomètres Mᵢ peut être, par exemple supérieur ou égal à 2, de préférence supérieur ou égal à 16, par exemple égal à 32, notamment lorsqu'il s'agit de magnétomètres triaxes. Le réseau de magnétomètres Mᵢ comporte cependant au moins trois axes de mesure distants les uns des autres et non parallèles deux à deux.

Les magnétomètres Mᵢ sont fixés à la surface d'appui Sa sans degré de liberté, et peuvent être situés au niveau de la face arrière d'une plaque 21 dont la face avant forme la surface d'appui Sa, celle-ci étant réalisée dans un matériau non magnétique. Ils sont ici alignés en lignes et colonnes, mais peuvent être positionnés mutuellement de manière sensiblement aléatoire. Les positions des magnétomètres Mᵢ sont connues. Par exemple, elles peuvent être comprises entre 1cm et 10cm, par exemple 5cm.

Les magnétomètres Mᵢ présentent chacun au moins un axe de mesure, par exemple trois axes, notés xᵢ, y;, z;. Chaque magnétomètre mesure donc l'amplitude et la direction du champ magnétique ambiant Bᵢ dont une contribution est générée par l'aimant. Plus précisément, chaque magnétomètre Mᵢ mesure la norme de la projection orthogonale du champ magnétique ambiant Bᵢ suivant les axes xᵢ, yᵢ, z; du magnétomètre. Un paramètre de calibration des magnétomètres Mᵢ peut être le bruit associé aux magnétomètres, ici de l'ordre de 0,3 à 0,4µT. Par champ magnétique ambiant B, on entend le champ magnétique non perturbé par un quelconque élément magnétique, formé notamment d'une contribution terrestre B^{terr} de l'ordre de 50µT, auquel s'ajoute le champ magnétique B^{a} généré par l'aimant. D'autres contributions magnétiques peuvent s'ajouter, comme une contribution associée au bruit des capteurs et une contribution liée à une erreur de décalage (*offset,* en anglais), lesquelles sont négligées ici.

Le dispositif de localisation 20 comporte en outre une unité de calcul électronique 22 apte à déterminer la position et l'orientation de l'aimant 15 dans le repère réel Rr définissant un vecteur d'état noté Xₐₗᵣ, à partir des mesures des magnétomètres Mᵢ. De plus, comme décrit plus loin, l'unité de calcul 22 est apte à déterminer un vecteur d'état X_{l|v} associé au lanceur 10 dans un repère tridimensionnel virtuel Rv, un vecteur d'état X_{b|v} associé au bras de lancement 12 dans le repère virtuel Rv, et une position P_{p|v} d'un projectile 32 dans le repère virtuel Rv. L'unité de calcul 22 est également adaptée à identifier une phase d'armement A du bras de lancement 12, ainsi que le tir du projectile 32 et sa trajectoire T_{p|v} dans le repère virtuel Rv. Elle est adaptée enfin à construire une image à afficher, et à commander l'interface graphique 2 pour afficher l'image construite.

Pour cela, chaque magnétomètre Mᵢ est électriquement connecté à l'unité de calcul 22 par un bus de transmission d'informations (non représenté). L'unité de calcul 22 comporte un processeur programmable 23 apte à exécuter des instructions enregistrées sur un support d'enregistrement d'informations. Il comporte en outre une mémoire 24 contenant les instructions nécessaires pour la mise en oeuvre du procédé de localisation de l'aimant 15 et de commande de l'interface graphique 2. La mémoire 24 est également adaptée à stocker les informations calculées à chaque instant de mesure.

L'unité de calcul 22 implémente un modèle mathématique associant la position de l'aimant 15 dans le repère réel Rr, ainsi que l'orientation et l'intensité de son moment magnétique m, aux mesures des magnétomètres Mᵢ. Ce modèle mathématique est construit à partir des équations de l'électromagnétisme, en particulier de la magnétostatique, et est paramétré notamment par les positions et orientations des magnétomètres dans le repère réel Rr. Ici, ce modèle est non linéaire. L'unité de calcul met en oeuvre un algorithme d'estimation de sa solution tel que, par exemple, un filtrage bayésien (par ex. filtre de Kalman étendu) ou une optimisation, voire tout autre algorithme du même type.

De préférence, pour pouvoir approximer l'aimant 15 à un dipôle magnétique, la distance entre l'aimant 15 et chaque magnétomètre Mᵢ est supérieure à 2, voire 3 fois la plus grande dimension de l'aimant. Cette dimension peut être inférieure à 20cm, voire inférieure à 10cm, voire à 5cm. L'aimant 15 peut être modélisé par un modèle dipolaire, entre autres, en fonction notamment de la distance entre l'aimant et chaque magnétomètre Mᵢ du réseau.

Par ailleurs, l'unité de calcul 22 comporte, enregistré dans sa mémoire 24, un fichier numérique 25 codant l'environnement virtuel Ev dans le repère virtuel Rv, et comporte également, enregistré dans sa mémoire 24, un modèle numérique 26 du lanceur 10 permettant notamment de fournir une représentation numérique 31 du lanceur 10 dans le repère virtuel Rv.

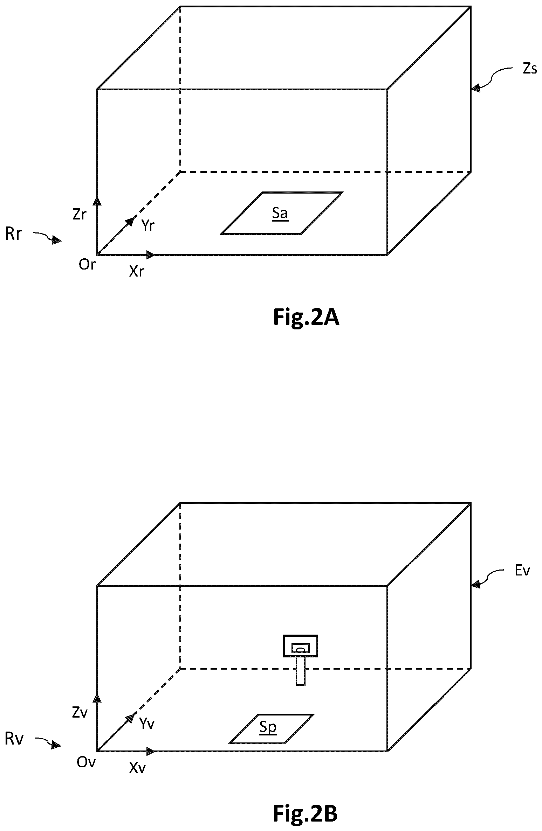

Les figures 2A et 2B sont des vues schématiques et partielles, en perspective, de la zone de suivi Zs (fig.2A) et de l'environnement virtuel Ev (fig.2B).

Sur la fig.2A, la zone de suivi Zs est représentée de manière schématique. La surface d'appui Sa est située dans la zone de suivi Zs. Chaque point dans la zone de suivi Zs présente des coordonnées définies dans le repère réel Rr. Dans cet exemple, l'origine Or du repère réel Rr est située en bordure de la zone de suivi Zs. La zone de suivi Zs est la zone physique de l'espace dans laquelle le SNR est supérieur à une valeur seuil prédéfinie, et dans laquelle un utilisateur peut manipuler le lanceur 10, par exemple à la main.

Sur la fig.2B, l'environnement virtuel Ev est représenté de manière schématique. Une surface de positionnement Sp d'une représentation numérique 31 du lanceur 10 est illustrée, et correspond à une représentation numérique de la surface d'appui Sa. L'environnement virtuel Ev peut comporter un sol, des surfaces, des murs etc... Dans cet exemple, l'environnement virtuel Ev est un terrain de basket et comporte un panier de basket 30.3 disposé entre la surface de positionnement Sp et un mur de fond 30.2. Chaque point de l'environnement virtuel présente des coordonnées définies dans un repère tridimensionnel, ici direct, dit virtuel Rv (Ov,Xv,Yv,Zv). Dans cet exemple, l'origine Ov du repère virtuel Rv est située en bordure de l'environnement virtuel Ev. L'environnement virtuel Ev est codé dans un fichier numérique 25 enregistré dans la mémoire 24 de l'unité de calcul 22. Autrement dit, le fichier numérique 25 fournit la position des points de chacun des éléments qui définissent l'environnement virtuel Ev. Les éléments ou certains éléments de l'environnement virtuel Ev peuvent être statiques ou animés.

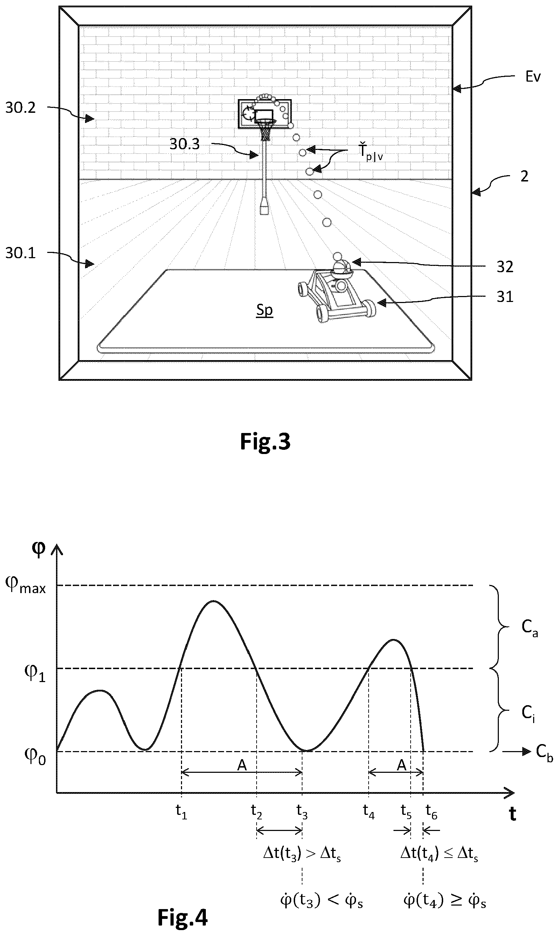

La figure 3 est une vue schématique d'une interface graphique 2 affichant une image bidimensionnelle de l'environnement virtuel Ev dans lequel est située une représentation numérique 31 du lanceur 10 ainsi que le projectile 32. L'environnement virtuel Ev est ici une zone d'un terrain de basket et est formé par un sol 30.1, un mur de fond 30.2 et un panier de basket 30.3. La zone de positionnement Sp est illustrée et des représentations numériques 31 du lanceur et du projectile 32 sont affichées dans la zone de positionnement Sp. Dans cette image, le lanceur 10 se trouve dans une configuration d'armement A dans laquelle le tir du projectile 32 est possible. Une trajectoire estimée Ť_{p|v} du projectile 32 est affichée.

Par ailleurs, l'unité de calcul 22 intègre une relation de correspondance F entre le repère réel Rr et le repère virtuel Rv. Autrement dit, à chaque point de la zone de suivi dans le repère réel Rr est associé un et un seul point de l'environnement virtuel Ev dans le repère virtuel Rv. Cette relation de correspondance F n'est pas nécessairement une fonction bijective, dans la mesure où l'environnement virtuel Ev peut être un espace tridimensionnel plus important que celui de la zone de suivi Zs.

L'unité de calcul 22 intègre également un modèle numérique 26 du lanceur 10 et de son bras de lancement 12 permettant d'associer à un vecteur d'état X_{a|r} de l'aimant 15 représentatif de la position et de l'orientation de l'aimant dans le repère réel Rr :
- un vecteur d'état X_{l,v} du lanceur 10 représentatif de la position et de l'orientation du lanceur 10 dans le repère virtuel Rv, et
- un vecteur d'état X_{b,v} du bras de lancement 12 représentatif de la position et/ou de l'orientation du bras de lancement 12 dans le repère virtuel Rv.

Autrement dit, connaissant la position et l'orientation de l'aimant 15 dans le repère réel Rr, l'unité de calcul 22 peut en déduire la position et l'orientation du lanceur 10 dans le repère virtuel Rv, formalisées dans le vecteur d'état X_{l|v}. Le modèle numérique 26 comporte également des informations concernant le type de lanceur (catapulte, canon...) ainsi que ses dimensions. Ainsi, l'unité de calcul 22 peut construire une représentation numérique 31 du lanceur 10 dans le repère virtuel Rv.

De plus, connaissant la position et l'orientation de l'aimant 15 dans le repère réel Rr, l'unité de calcul 22 peut en déduire la position et/ou l'orientation du bras de lancement 12 dans le repère virtuel Rv, formalisées dans le vecteur d'état X_{b|v}. Le modèle numérique 26 comporte également des informations concernant le type de bras de lancement 12 et son mouvement contraint par rapport à la structure 11 du lanceur 10 (liaison pivot, glissière... ; intensité de la force de rappel...) ainsi que ses dimensions. Ainsi, l'unité de calcul 22 peut construire la représentation numérique du bras de lancement 12 dans le repère virtuel Rv. Notons ici que le vecteur d'état X_{b|v} du bras de lancement 12 peut être issu voire compris dans le vecteur d'état X_{l|v} du lanceur 10, dans le sens où il peut être formé d'une ou plusieurs coordonnées du vecteur d'état X_{l|v}.

Enfin, l'unité de calcul 22 peut intégrer un modèle numérique du projectile 32 à lancer dans l'environnement virtuel Ev. Ce modèle numérique peut être compris dans le modèle numérique 26 associé au lanceur 10 et au bras de lancement 12. Les caractéristiques du projectile 32 à représenter dans l'environnement virtuel Ev, à savoir ses dimensions et sa masse, peuvent ainsi être définies dans le modèle numérique. L'unité de calcul peut comporter un ou plusieurs processeurs et une ou plusieurs mémoires, éventuellement déportés les uns des autres.

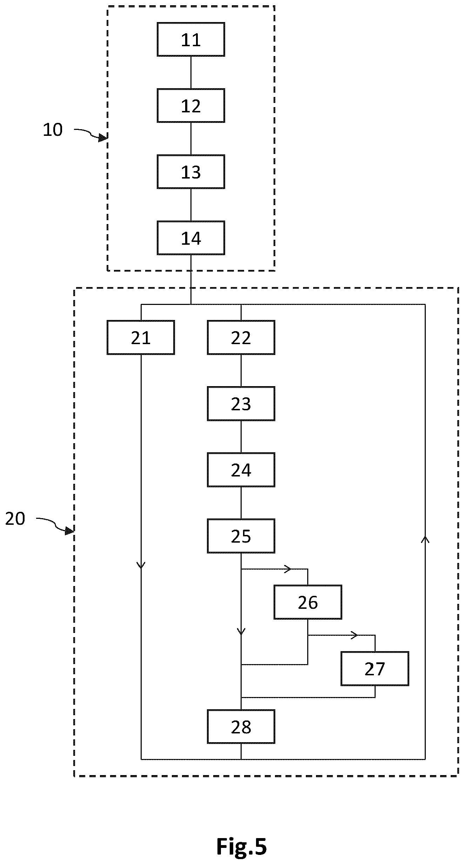

La figure 5 est un organigramme d'un procédé de commande de l'interface graphique 2 selon un mode de réalisation.

Dans cet exemple, l'environnement virtuel Ev est formé d'une zone tridimensionnelle de jeu de basket formé d'un sol 30.1 comportant une surface de positionnement Sp dans laquelle la représentation numérique 31 du lanceur 10 est destinée à être affichée, d'un mur de fond 30.2, et d'un panier de basket 30.3 disposé entre la surface de positionnement Sp et le mur de fond 30.2.

Le procédé de commande comporte une phase d'initialisation 10.

Lors d'une étape 11, le fichier numérique codant l'environnement virtuel Ev est enregistré dans la mémoire 24 de l'unité de calcul 22. Ainsi, chaque point des éléments définissant l'environnement virtuel Ev (sol, mur, objet...) est défini dans le repère virtuel Rv. Dans cet exemple, la surface de positionnement Sp, le sol 30.1, le mur de fond 30.2, et le panier de basket 30.3 sont définis dans le repère virtuel Rv.

Lors d'une étape 12, le modèle numérique 26 du lanceur 10 et du bras de lancement 12 est enregistré dans la mémoire 24 de l'unité de calcul 22. Comme mentionné précédemment, le modèle numérique 26 permet de représenter le lanceur 10 et son bras de lancement 12 dans le repère virtuel Rv à partir du vecteur d'état X_{a|r} de l'aimant 15. Le modèle numérique 26 peut également intégrer des données relatives au projectile 32 à représenter (dimensions...).

Lors d'une étape 13, les dimensions de la zone de suivi Zs sont enregistrées dans la mémoire 24 de l'unité de calcul 22. La relation de correspondance F, préenregistrée dans la mémoire 24 de l'unité de calcul 22 permet d'assurer la correspondance entre une position dans le repère réel Rr et une position dans le repère virtuel Rv. Dans cet exemple, les axes Xr et Xv sont choisis parallèles entre eux, tout comme le sont Yr et Yv, ainsi que les axes Zr et Zv.

Lors d'une étape 14, l'unité de calcul 22 détermine les dimensions du champ de prise de vue. Celui-ci peut être défini par un premier angle dans un plan horizontal (Xv,Yv) et un deuxième angle dans un plan vertical (Yv,Zv). L'orientation du champ de vue suivant un axe optique peut être choisie constante ou peut dépendre de l'orientation du lanceur 10 dans le repère virtuel Rv.

Le procédé de commande comporte ensuite une phase d'utilisation 20 de l'appareil 1 pour commander l'interface graphique 2 et afficher les images représentant le lanceur 10 ainsi que le lancement du projectile 32 dans l'environnement virtuel Ev.

Lors d'une étape 21, l'utilisateur place le lanceur 10 dans la zone de suivi Zs et au contact de la surface d'appui. Il manipule le lanceur 10, c'est-à-dire qu'il en modifie la position dans le plan horizontal (Xr,Yr) et/ou son orientation. Le lanceur 10 reste cependant au contact de la surface d'appui Sa.

Dans un premier temps, le bras de lancement 12 peut occuper sa position de repos, ici la position de butée, c'est-à-dire qu'il est ici maintenu au contact de la portion d'arrêt 13 de la structure rigide 11 par l'organe de rappel. L'angle d'inclinaison ϕ est alors égal à l'angle de repos ϕₒ. L'utilisateur peut modifier la position et/ou l'orientation du lanceur 10 dans la zone de suivi Zs et observer la représentation numérique 31 du lanceur 10 dans l'environnement virtuel Ev telle qu'affichée par l'interface graphique.

L'utilisateur peut actionner le bras de lancement 12 en vue de procéder au lancement d'un projectile 32 dans l'environnement virtuel. Pour cela, il écarte le bras de lancement 12 vis-à-vis de la position de butée. L'angle d'inclinaison ϕ augmente alors et devient supérieur ou égal à une valeur seuil prédéfinie ϕ₁. Le lanceur 10 présente alors une configuration d'armement Cₐ propice au lancement du projectile 32. En revanche, lorsque l'angle d'inclinaison ϕ reste compris entre l'angle de repos ϕ₀ et la valeur seuil ϕ₁, on considère que le lanceur 10 présente une configuration intermédiaire Cᵢ qui ne conduit pas au lancement du projectile 32.

Enfin, l'utilisateur peut relâcher plus ou moins brusquement le bras de lancement 12. Si le lanceur 10 présentait la configuration intermédiaire Cᵢ à l'instant du relâchement, le bras de lancement 12 revient dans sa position de butée C_{b} sans qu'un tir du projectile 32 ne soit effectué. En revanche, si le lanceur 10 présentait la configuration d'armement Cₐ à l'instant du relâchement, le tir du projectile 32 dans l'environnement virtuel Ev est alors effectué.

La figure 4 illustre un exemple d'évolution de l'angle d'inclinaison ϕ de l'aimant 15 en fonction du temps.

L'angle d'inclinaison ϕ est ici un premier facteur K1 représentatif de l'armement du bras de lancement 12, ce premier facteur étant issu d'un vecteur d'état X_{b|v} déterminé par l'unité de calcul 22 sur la base des mesures du champ magnétique de l'aimant 15. Ce premier facteur est plus précisément représentatif de la position du bras de lancement 12 et donc de la configuration (butée C_{b}, intermédiaire Cᵢ, armement Cₐ) dans laquelle se trouve le lanceur 10 à l'instant de mesure. Pour d'autres types de lanceurs, la configuration de butée C_{b} peut être une configuration de repos. Bien entendu, d'autres indicateurs issus du vecteur d'état X_{b|v} peuvent être utilisés comme premier facteur K1 représentatif de l'armement du bras de lancement 12. Il peut ainsi s'agir d'un écart |ϕ-ϕₒ| entre l'angle d'inclinaison ϕ à l'instant de mesure et l'angle de repos ϕ₀, voire d'un écart normalisé |ϕ-ϕ₀|/|ϕₘₐₓ-ϕ₀|. Il peut également s'agir de la position verticale de l'aimant 15 suivant l'axe Zr ou du bras de lancement 12 suivant l'axe Zv, ou de la position horizontale de l'aimant 15 dans le plan (Xr,Yr) voire du bras de lancement 12 dans le plan (Xv,Yv). Le facteur d'armement K1 peut être issu du vecteur d'état X_{b|v} du bras de lancement 12 ou du vecteur d'état X_{a|r} de l'aimant 15. Il peut ainsi s'agir de l'angle d'inclinaison du bras de lancement 12 dans le repère virtuel Rv ou de l'angle d'inclinaison de l'aimant 15 dans le repère réel Rr. Ces deux angles sont reliés entre eux du fait de la fixation sans degré de liberté de l'aimant 15 sur le bras de lancement 12 du lanceur 10. Dans cet exemple, on considère que ces deux angles sont égaux.

Dans un premier temps, l'utilisateur actionne le bras de lancement 12, de sorte que l'angle d'inclinaison ϕ(t) augmente à partir de la valeur de repos ϕ₀. Il augmente jusqu'à un premier maximum inférieur à ϕ₁ de sorte que le lanceur 10 reste dans la configuration intermédiaire Cᵢ, puis revient à la valeur de repos ϕ₀. Le bras de lancement 12 revient donc à sa position de butée C_{b}.

Ensuite, l'utilisateur actionne à nouveau le bras de lancement 12, de sorte que l'angle d'inclinaison ϕ(t) augmente jusqu'à un deuxième maximum supérieur à la valeur seuil ϕ₁. Le lanceur 10 occupe alors la configuration d'armement Cₐ et une phase d'armement A est alors identifiée : un tir du projectile 32 est alors possible. La phase d'armement A s'étend à partir de l'instant de passage de la configuration intermédiaire Cᵢ à la configuration d'armement Cₐ et jusqu'à l'instant où le lanceur 10 reprend sa configuration de butée C_{b}. Dans cet exemple, l'utilisateur passe le bras de lancement 12 dans la configuration d'armement Cₐ à l'instant t₁ (ϕ(t₁)≥ϕ₁) puis ramène le bras de lancement 12 dans la configuration de butée à l'instant t₃ (ϕ(t₃)=ϕ₀).

Le tir du projectile 32 est ensuite effectué ou non, en fonction d'un deuxième facteur K2 représentatif du lancement du projectile 32, ce facteur étant issu du vecteur d'état X_{b|v} déterminé par l'unité de calcul sur la base des mesures du champ magnétique de l'aimant 15, ou plus directement à partir du vecteur d'état X_{a|r} de l'aimant 15.

Différents facteurs peuvent être utilisés. Selon un premier exemple, on peut comparer le délai Δt(t₃)=t₃-t₂ entre l'instant de passage de la configuration Cₐ à la configuration Cᵢ, ici noté t₂, avant l'instant t₃. Lorsque ce délai Δt(t₃) est supérieur à un délai seuil Δtₛ prédéfini, on estime que le tir du projectile 32 n'est pas effectué : l'utilisateur a par exemple simplement ramené avec sa main le bras de lancement 12 dans sa position de repos, ici de butée. Si en revanche, il est inférieur ou égal au délai seuil Δtₛ, on estime que le tir du projectile 32 est effectué : l'utilisateur a relâché brusquement le bras de lancement 12 qui a été ramené rapidement dans sa position de repos, ici de butée par l'organe de rappel. Plus généralement, on identifie le tir du projectile 32 lorsque le facteur de lancement K2 est supérieur ou égal à une valeur seuil prédéfinie K2s. Aussi, dans cet exemple, le facteur de lancement K2 est 1/Δt(t₃) et la valeur seuil K2s est ici 1/Δtₛ.

Selon un autre exemple, le deuxième facteur de lancement peut être la vitesse angulaire instantanée du bras de lancement 12 à l'instant où il atteint la position de repos (ici de butée) : ϕ̇(t₃). Si cette vitesse angulaire instantanée est inférieure à une valeur seuil ϕ̇ₛ prédéfinie, on estime que le tir du projectile 32 n'est pas effectué. Si en revanche, la vitesse angulaire instantanée est supérieure ou égale à la valeur seuil ϕ̇ₛ, on estime que le tir du projectile 32 est effectué.

Bien entendu, d'autres indicateurs issus du vecteur d'état X_{b|r} ou du vecteur d'état X_{a|r} peuvent être utilisés. Ainsi, on peut s'agir de la vitesse angulaire moyenne calculée à l'instant de mesure t₃ sur la base d'une moyenne glissante sur N instants de mesure antérieurs, voire de la valeur maximale de la vitesse angulaire choisie parmi l'instant t₃ et les N instants de mesure antérieurs, voire encore de la vitesse angulaire à l'instant où l'accélération présente un point d'inflexion. Ici, le deuxième facteur est calculé sur la base de la vitesse angulaire mais il peut s'agir de la vitesse rectiligne basée sur une variation de la position verticale ou horizontale du bras de lancement 12.

Dans l'exemple illustré sur la fig.4, le facteur de lancement K2, qu'il s'agisse du délai 1/Δt(t₃) ou de la vitesse angulaire instantanée ϕ(t₃), indique que le tir du projectile 32 n'est pas effectué.

Enfin, l'utilisateur actionne à nouveau le bras de lancement 12, de sorte que l'angle d'inclinaison ϕ(t) augmente jusqu'à un troisième maximum supérieur à la valeur seuil ϕ₁. Le lanceur 10 occupe alors à nouveau la configuration d'armement Cₐ et une phase d'armement A est alors identifiée à partir de l'instant t₄ : un tir du projectile 32 est alors possible. L'utilisateur lâche alors le bras de lancement 12, qui rejoint brusquement sa configuration de butée C_{b} à l'instant t₆ (ϕ(t₆)=ϕ₀).

Ici, le facteur de lancement K2 indique que le tir du projectile 32 est effectué. En effet, le délai 1/Δt(t₆)=t₆-t₅ est supérieur ou égal au délai seuil 1/Δtₛ. De même, la vitesse angulaire instantanée ϕ(t₆) est supérieure ou égale à la vitesse seuil ϕ̇ₛ. Comme décrit plus loin, l'unité de calcul détermine alors la trajectoire effective T_{p|v} du projectile 32 dans le repère virtuel Rv.

En référence à la fig.5, les étapes effectuées par le dispositif de localisation en parallèle de l'étape 21 de manipulation du lanceur 10 dans la zone de suivi Zs sont maintenant décrites. Ces étapes sont effectuées de manière itérative à un instant de mesure tₙ, le temps étant discrétisé à une fréquence d'échantillonnage déterminée, par exemple à 140Hz. A chaque itération de rang n est associé un instant de mesure tₙ, également appelé instant courant.

Lors d'une étape 22, les magnétomètres mesurent le champ magnétique ambiant à l'instant courant, et notamment la contribution du champ magnétique ambiant générée par l'aimant 15, lequel est fixé au bras de lancement 12 du lanceur 10.

Ensuite, lors d'une étape 23, l'unité de calcul reçoit les mesures du champ magnétique ambiant, en déduit la contribution du champ magnétique généré par l'aimant 15, et détermine le vecteur d'état X_{a|r} associé à l'aimant 15 à l'instant courant dans le repère réel Rr. Le vecteur d'état X_{a|r} comporte la position et l'orientation de l'aimant 15 dans le repère réel Rr. Cette estimation du vecteur d'état peut être effectuée à l'aide d'un algorithme d'estimation de la position et de l'orientation de l'aimant 15 de type bayésien, par exemple un filtre de Kalman étendu, ou à l'aide d'une méthode d'optimisation (descente de gradient...), ou à l'aide de tout autre algorithme du même type. Un exemple d'estimation d'un vecteur d'état associé à un aimant 15 est notamment décrit dans la demande WO2018/219891.

Lors d'une étape 24, l'unité de calcul détermine un vecteur d'état X_{l,v} associé au lanceur 10 et un vecteur d'état X_{b|v} associé au bras de lancement 12, à partir du vecteur d'état X_{a|r} de l'aimant 15 et du modèle numérique enregistré. Le vecteur d'état X_{l,v} comporte ainsi la position et l'orientation du lanceur 10 dans le repère virtuel Rv. Et le vecteur d'état X_{b|v} comporte la position et/ou l'orientation du bras de lancement 12 dans le repère Rv, ici l'angle d'inclinaison ϕ(t) de l'aimant 15. Ainsi, le lanceur 10 peut être représenté numériquement avec son bras de lancement 12 dans l'environnement virtuel Ev.

Lors de cette étape, l'unité de calcul détermine également la position P_{p|v} du projectile 32 dans le repère virtuel Rv, à partir des vecteurs d'état X_{l|v} et X_{b|v}, et à partir du modèle numérique du projectile 32. Le projectile 32 peut ainsi être représenté numériquement dans l'environnement virtuel Ev, ici reposant dans la portion de support 12.2 du bras de lancement 12, dont les coordonnées dans le repère Rv sont déduites d'au moins le vecteur d'état X_{b|v}.

Lors d'une étape 25, l'unité de calcul détermine le premier facteur K1 représentatif de l'armement du bras de lancement 12, ce premier facteur K1 étant issu du vecteur d'état X_{b|v} déterminé par l'unité de calcul sur la base du vecteur d'état X_{a|r}. Il s'agit par exemple de l'angle d'inclinaison ϕ(tₙ) à l'instant courant.

La phase d'armement A est identifiée lorsqu'une condition sur le facteur d'armement K1 est vérifiée lorsque le facteur d'armement K1 est supérieur ou égal à une valeur seuil prédéfinie K1s, et ici qui illustre le fait que le bras de lancement 12 a été armé mais n'a pas encore rejoint la position de butée. Autrement dit, la phase d'armement A est identifiée lorsque l'instant courant tₙ est supérieur ou égal à un instant de référence t_{ref} pour lequel le lanceur 10 est entré dans la configuration d'armement Cₐ mais pour lequel le bras de lancement 12 reste distant de la position de butée, c'est-à-dire ici : ∀tₙ≥t_{ref} / ϕ(tₙ) > ϕ₀ avec ϕ(t_{ref})≥ϕ₁. Ici, le facteur d'armement K1 est l'angle d'inclinaison (ϕ(tₙ) et la valeur seuil prédéfinie est ϕ₁.

Lorsque la phase d'armement A est identifiée, une trajectoire estimée Ť_{p|v} du projectile 32 dans le repère virtuel Rv peut être déterminée par l'unité de calcul, sur la base de la position P_{p|v} du projectile 32, et sur la base du vecteur d'état X_{b|v} du bras de lancement 12 (par exemple sur la base de l'angle d'inclinaison ϕ à l'instant courant), et sur la base du vecteur d'état X_{l|v} du lanceur 10 (position et orientation). Cette trajectoire estimée Ť_{p|v} peut être déterminée à partir d'un modèle physique de tir balistique connu et classique, indiquant la trajectoire du projectile 32, c'est-à-dire sa position dans le repère virtuel Rv au cours du temps, à partir du vecteur vitesse du projectile 32 à la position de butée (intensité, orientation), des coordonnées de la position de butée, et du paramètre représentatif de la gravité dans l'environnement virtuel Ev.

Comme l'illustre la fig.3, la trajectoire estimée Ť_{p|v} peut être illustrée sur l'image construire et affichée par l'interface graphique, illustrant la trajectoire supposée que peut prendre le projectile 32 si le bras de lancement 12 était lâché brusquement par l'utilisateur, et illustrant le point d'impact du projectile 32 sur un objet de l'environnement virtuel Ev (ici le panier de basket).

Dans le cas où la phase d'armement A n'est pas identifiée, le procédé de commande se poursuit en allant directement à l'étape 28. En revanche, dans le cas où la phase d'armement A est identifiée, le procédé de commande se poursuit avec l'étape 26.

Lors d'une étape 26, l'unité de calcul détermine le deuxième facteur K2 représentatif du lancement du projectile 32, ce facteur de lancement K2 étant issu du vecteur d'état X_{b|v} déterminé par l'unité de calcul sur la base du vecteur d'état X_{a|r}. Il s'agit ici de la vitesse angulaire instantanée ϕ̇(tₙ) lorsque le bras de lancement 12 a atteint sa position de butée.

Le tir du projectile 32 est identifié lorsqu'une condition sur le facteur de lancement K2 est vérifiée, à savoir lorsque le facteur de lancement K2 est supérieur ou égal à une valeur seuil prédéfinie K2s, et ici lorsqu'à l'instant courant où l'angle d'inclinaison ϕ(tₙ) est égal à l'angle de repos ϕ₀ (ϕ(tₙ)= ϕ₀), la vitesse angulaire instantanée ϕ̇(tₙ) est supérieure ou égale à une valeur seuil ϕ̇ₛ prédéfinie : ϕ̇(tₙ) ≥ ϕ̇ₛ.

Dans le cas où le tir du projectile 32 n'est pas identifié (i.e. lorsqu'il n'y a pas lancement du projectile 32), le procédé de commande se poursuit en allant directement à l'étape 28. En revanche, dans le cas où le tir du projectile 32 est identifié, le procédé de commande se poursuit avec l'étape 27.

Lors d'une étape 27, la trajectoire effective T_{p|v} du projectile 32 dans le repère virtuel Rv est déterminée par l'unité de calcul 22, sur la base de la position P_{p|v} du projectile 32 dans la position de butée, et sur la base du vecteur d'état X_{b|v} du bras de lancement 12 (par exemple sur la base de l'angle d'inclinaison ϕ à l'instant courant), et sur la base du vecteur d'état X_{l|v} du lanceur 10 (position et orientation). Elle prend en compte par exemple la vitesse effective du projectile 32 à la position de butée (intensité, orientation), des coordonnées de la position de butée, et du paramètre représentatif de la gravité dans l'environnement virtuel Ev.

Cette trajectoire effective Ť_{p|v} est enregistrée et vient remplacer la trajectoire estimée Ť_{p|v} précédemment. Aussi, l'unité de calcul 22 détermine les positions successives du projectile 32 dans le repère virtuel Rv aux différents instants ultérieurs, sur une durée de temps de vol également déterminée.

Lors d'une étape 28, l'unité de calcul 22 construit une image bidimensionnelle de l'environnement virtuel Ev, du lanceur 10 à partir du vecteur d'état X_{l|v}, du bras de lancement 12 à partir du vecteur d'état X_{b-v}, et de la position du projectile 32 éventuellement issue de la trajectoire effective T_{p|v} déterminée précédemment. Comme décrit notamment dans le brevet EP2994813 B1 mentionné précédemment, l'image est construite en tenant compte des angles et de l'axe optique de champ de prise de vue définis précédemment. L'unité de calcul 22 commande ensuite l'affichage de l'image construite sur l'interface graphique 2.

Les étapes 22 à 28 sont ensuite réitérées à une fréquence d'échantillonnage définie, laquelle peut être constante ou non dans le temps. Au cours des instants de mesure qui suivent le tir du projectile 32 et appartiennent au temps de vol déterminé, les étapes 26 et 27 ne sont pas effectuées. La position P_{p|v} du projectile 32 dans le repère virtuel Rv est issue de la trajectoire effective T_{p|v} prédéterminée.

Ainsi, un utilisateur peut très facilement et de manière particulièrement intuitive, non seulement commander l'affichage d'images sur une interface graphique au moyen d'un objet tridimensionnel (lanceur 10) muni d'un aimant 15, mais également agir sur l'environnement virtuel Ev représenté, ici en lançant un projectile 32 dans cet environnement virtuel Ev. La manipulation du lanceur 10 permet ainsi d'orienter et de positionner le projectile 32 dans l'environnement virtuel Ev de manière intuitive et particulièrement précise.

L'appareil de commande est particulièrement simplifié dans la mesure où l'identification du tir du projectile 32 ne nécessite pas d'équiper le lanceur 10 dans la zone de suivi par des moyens complexes d'analyse de la localisation du lanceur 10 et de l'actionnement du bras de lancement 12. En effet, seul un aimant 15 équipe le lanceur 10, lequel peut alors présenter une structure mécanique simple et être réalisé en un matériau non magnétique peu coûteux tel que le plastique. Le tir du projectile 32 n'est pas non plus commandé par l'actionnement d'un bouton, par exemple d'un clavier ou d'une souris, mais par le simple relâchement par l'utilisateur du bras de lancement 12, ce qui permet d'améliorer l'expérience utilisateur.

De plus, la représentation numérique du lanceur 10 et de l'actionnement du bras de lancement 12 peut être fluide et précise dans la mesure où la fréquence de mesure peut être relativement élevée, par exemple peut être de l'ordre de 140Hz. Aussi, chaque instant de mesure, et éventuellement chaque image affichée, peut être séparé de l'instant suivant de quelques millisecondes seulement, ce qui permet de reproduire de manière fidèle la manipulation par l'utilisateur du lanceur 10 dans la zone de suivi.

La précision est particulièrement élevée notamment dans la mesure où le lanceur 10 reste au contact de la surface d'appui dans la zone de suivi, de sorte que le rapport SNR du signal sur bruit reste particulièrement élevé et le degré de liberté de manipulation du lanceur 10 dans la zone de suivi est réduit aux deux dimensions du plan horizontal (Xr,Yr) du fait du contact sur la surface d'appui. La précision de la localisation du lanceur 10 et de l'actionnement du bras de lancement 12 est alors importante.

Il est alors possible d'interagir avec des éléments de l'environnement virtuel Ev qui ne sont pas situés dans la représentation numérique de la zone de suivi, ceci lorsque l'environnement virtuel Ev est un espace 3D plus important que celui de la zone de suivi. Cette interaction peut déclencher des actions données dans l'environnement virtuel (mise en mouvement ou actionnement d'objet virtuel).

Des modes de réalisation particuliers viennent d'être décrits.

Ainsi, la fréquence d'échantillonnage associée à la localisation de l'aimant (par ex. 140Hz) la fréquence d'affichage des images construites, et la fréquence de mise à jour de la position de la représentation numérique du lanceur et du projectile peuvent être différentes les unes des autres.

Par ailleurs, à l'instant où le tir du projectile est identifié, la trajectoire T_{p|v} du projectile est alors déterminée, comme décrit en détail précédemment. Ensuite, lors du temps de vol, la position P_{p|v} du projectile à l'instant courant est définie à partir de la trajectoire déterminée précédemment, et éventuellement à partir de paramètres relatifs à l'environnement virtuel. A titre d'exemple, au cours du temps de vol, la direction de la gravité peut être modifiée, auquel cas la position P_{t|v} du projectile est actualisée en conséquence.

Comme mentionné précédemment, la position de butée peut être une simple position de repos dans laquelle le bras de lancement n'est pas au contact d'une portion d'arrêt. C'est le cas notamment d'un lance-pierre, voire éventuellement du canon. Les étapes d'identification de l'armement et du tir décrites précédemment tiennent compte alors de la position de repos, à la place de la position de butée.

## Revendications

1. Procédé de commande d'une interface graphique (2) pour afficher des images d'une représentation numérique (31) d'un objet tridimensionnel (10), dans un environnement virtuel (Ev), et comportant une structure (11) réalisée en un matériau non magnétique, le procédé étant mis en oeuvre par une unité de calcul (22), comportant les étapes suivantes :
∘ fourniture d'un dispositif de localisation (20) de l'objet tridimensionnel (10) dans une zone de suivi (Zs), comportant :
• un réseau de magnétomètres (Mᵢ) fixés à une surface d'appui (Sa),
• l'unité de calcul (22) étant connectée au réseau de magnétomètres et à l'interface graphique,
• la zone de suivi (Zs) de l'objet tridimensionnel (10)par rapport au réseau de magnétomètres étant prédéfinie, et un repère tridimensionnel dit réel (Rr) étant associé à la zone de suivi ;
∘ enregistrement (11,12) dans l'unité de calcul (22) de :
• un fichier numérique (25) codant l'environnement virtuel (Ev) dans un repère tridimensionnel dit virtuel (Rv), le repère virtuel (Rv) étant associé au repère réel (Rr) par une relation de correspondance (F) prédéfinie ;
• un modèle numérique (26) permettant d'associer, à un vecteur d'état X_{a|r} d'un aimant (15) représentatif de la position et de l'orientation de l'aimant dans le repère réel (Rr), un vecteur d'état X_{b,v} de l'objet tridimensionnel (10)dans le repère virtuel (Rv), et permettant d'obtenir une représentation numérique (31) de l'objet tridimensionnel (10)dans le repère virtuel (Rv) ;
∘ manipulation (21), par un utilisateur, de l'objet tridimensionnel (10), celui-ci étant situé dans la zone de suivi ;
∘ mesure (22), par le réseau de magnétomètres (Mᵢ), d'un champ magnétique généré par l'aimant (15) à différents instants de mesure tₙ successifs ;
∘ détermination (23) du vecteur d'état X_{a|r} de l'aimant dans le repère réel (Rr), à l'instant de mesure tₙ, à partir des mesures du champ magnétique généré par l'aimant ;
∘ **caractérisé en ce que** : l'objet tridimensionnel (10) est appelé lanceur ; le lanceur (10) est adapté à lancer un projectile (32) dans un environnement virtuel (Ev) ; un bras de lancement (12) est assemblé à la structure (11) de manière mobile et contrainte en déplacement, un aimant (15) étant fixé au bras de lancement (12) ; le vecteur d'état X_{b|v} est celui du bras de lancement (12) du lanceur (10) et est représentatif de la position et/ou de l'orientation du bras de lancement (12) ;
∘ **en ce que**, lors de l'étape de manipulation (21), l'utilisateur manipule le bras de lancement (12) du lanceur (10), celui-ci étant en outre disposé au contact de la surface d'appui, le bras de lancement (12) étant susceptible d'être écarté d'une position de repos par l'utilisateur, un organe de rappel exerçant alors une force de rappel sur le bras de lancement en direction de la position de repos ;
∘ et **en ce que** le procédé comporte les étapes suivantes :
∘ détermination (24), à l'instant de mesure tₙ, du vecteur d'état X_{b|v} du bras de lancement (12) dans le repère virtuel (Rv), à partir du modèle numérique (26) préenregistré et du vecteur d'état X_{a|r} prédéterminé, ainsi que de la position P_{p|v} du projectile (32) à partir du modèle numérique (26) préenregistré et du vecteur d'état X_{b|v} prédéterminé ;
∘ identification (25) d'une phase d'armement (A) du bras de lancement (12), en fonction d'un facteur K1 dit d'armement défini à partir du vecteur d'état X_{b|v} à l'instant de mesure tₙ et à des instants de mesure antérieurs, la phase d'armement (A) étant identifiée lorsque le facteur d'armement K1 est supérieur ou égal à une valeur seuil K1s prédéfinie ;
∘ lorsque la phase d'armement (A) est identifiée, identification (26) du tir du projectile (32) en fonction d'un facteur K2 dit de lancement défini à partir du vecteur d'état X_{b|v} à l'instant de mesure tₙ, le tir du projectile (32) étant identifiée lorsque le facteur de lancement K2 est supérieur ou égal à une valeur seuil K2s prédéfinie ;
∘ lorsque le tir du projectile (32) est identifié, détermination (27) des positions successives P_{p|v} du projectile (32) dans le repère virtuel (Rv) à des instants de mesure ultérieurs ;
∘ construction (28) d'une image bidimensionnelle, représentant dans le repère virtuel (Rv) l'environnement virtuel (Ev), la représentation numérique (31) du lanceur, ainsi que le projectile (32), à partir du vecteur d'état X_{b|v} du bras de lancement et de la position P_{p|v} du projectile prédéterminés, puis commande de l'interface graphique (2) par l'unité de calcul (22) pour afficher l'image construite.

2. Procédé de commande selon la revendication 1, dans lequel :
∘ le modèle numérique permet également d'associer, au vecteur d'état X_{a|r} de l'aimant (15), un vecteur d'état X_{l,v} du lanceur (10) représentatif de la position et de l'orientation du lanceur dans le repère virtuel (Rv) ;
∘ lors de l'étape de manipulation (21), l'utilisateur manipule également le lanceur (10) ;
∘ lors de l'étape de détermination (24) du vecteur d'état X_{b|v} du bras de lancement, le vecteur d'état X_{l,v} du lanceur (10) est également déterminé à partir du modèle numérique (26) préenregistré et du vecteur d'état X_{a|r} prédéterminé ;
∘ lors de l'étape de construction (28), l'image bidimensionnelle affiche la représentation numérique (31) du lanceur à partir du vecteur d'état X_{l|v} du lanceur.

3. Procédé de commande selon la revendication 1 ou 2, dans lequel l'étape de détermination (27) des positions successives P_{p|v} du projectile (32) comporte une identification d'une intersection entre l'une des positions successives P_{p|v} déterminées et une surface de l'environnement virtuel (Ev) représentative d'un impact du projectile (32), et détermination d'un temps de vol entre l'instant de mesure auquel le tir du projectile est identifié et l'instant de mesure correspondant audit impact.

4. Procédé de commande selon la revendication 3, dans lequel, au cours des instants de mesure appartenant audit temps de vol, les étapes d'identification (25) d'une phase d'armement (A), d'identification (26) du tir du projectile, et de détermination (27) des positions successives P_{p|v} du projectile, ne sont pas effectuées.

5. Procédé de commande selon l'une quelconque des revendications 1 à 4, dans lequel le facteur d'armement K1 est défini à partir d'un angle d'inclinaison de l'aimant (15) lorsque le bras de lancement (12) est assemblé par liaison pivot sur la structure (11) et/ou d'une position suivant un axe orthogonal à la surface d'appui (Sa), et/ou d'une position suivant un plan parallèle à la surface d'appui (Sa).

6. Procédé de commande selon l'une quelconque des revendications 1 à 5, dans lequel la phase d'armement (A) est identifiée pour tout instant de mesure dit courant tₙ ultérieur à un instant de mesure de référence (t_{ref}) pour lequel le bras de lancement a présenté un facteur d'armement K1(t_{ref}) supérieur ou égal à la valeur seuil prédéfinie K1s, le bras de lancement à l'instant de mesure courant tₙ étant alors distant de la position de repos.

7. Procédé de commande selon l'une quelconque des revendications 1 à 6, dans lequel, lorsque la phase d'armement (A) est identifiée, une trajectoire estimée (Ť_{p|v}) du projectile dans le repère virtuel Rv est déterminée sur la base du vecteur d'état X_{l|v} du lanceur et du vecteur d'état X_{b|v} du bras de lancement, et une représentation numérique de la trajectoire estimée (Ť_{p|v}) est affichée sur l'image construite lors de l'étape (28) de commande de l'interface graphique (2).

8. Procédé de commande selon l'une quelconque des revendications 1 à 7, dans lequel le tir du projectile est identifié à un instant de mesure pour lequel le bras de lancement atteint sa position de repos, la phase d'armement (A) étant identifié à au moins l'instant de mesure précédent.

9. Procédé de commande selon l'une quelconque des revendications 1 à 8, dans lequel le facteur de lancement K2 est défini à partir d'une vitesse moyenne et/ou d'une vitesse instantanée du bras de lancement à au moins l'instant de mesure pour lequel il atteint sa position de repos.

10. Procédé de commande selon l'une quelconque des revendications 1 à 9, dans lequel le vecteur d'état X_{a|r} de l'aimant est déterminé par un algorithme d'estimation bayésien ou par une méthode d'optimisation.

11. Procédé de commande selon l'une quelconque des revendications 1 à 10, dans lequel l'environnement virtuel (Ev) est un espace tridimensionnel de dimensions supérieures à celles de la zone de suivi (Zs).

12. Support d'enregistrement d'informations, comportant des instructions pour l'exécution d'un procédé de commande selon l'une quelconque des revendications précédentes, lorsque ces instructions sont exécutées par une unité de calcul électronique.

13. Appareil de commande (1) d'une interface graphique (2) pour afficher des images d'une représentation numérique (31) d'un objet tridimensionnel (10), dans un environnement virtuel (Ev), , comportant :
∘ un objet tridimensionnel (10) comportant une structure (11) réalisée en un matériau non magnétique à laquelle est assemblé
∘ une interface graphique (2) ;
∘ un dispositif de localisation (20) comportant :
• un réseau de magnétomètres (Mᵢ) fixés à une surface d'appui (Sa) ;
• une unité de calcul (22) comportant une mémoire (24) dans laquelle est enregistrée un fichier numérique (25) codant l'environnement virtuel dans un repère virtuel (Rv), ainsi qu'un modèle numérique (26) de l'objet tridimensionnel (10), l'unité de calcul étant programmée pour :
- acquérir des mesures du champ magnétique généré par l'aimant ;
- calculer un vecteur d'état X_{a|r} de l'aimant dans un repère réel (Rr) associé à une zone de suivi (Zs) défini par rapport à la surface d'appui (Sa) ;
∘ **caractérisé en ce que** : l'objet tridimensionnel (10) est appelé lanceur ; l'appareil de commande (1) est adapté à la mise en oeuvre du procédé de commande selon l'une quelconque des revendications 1 à 11 ; un bras de lancement (12) est assemblé à la structure (11) de manière mobile et contrainte en déplacement, un aimant (15) étant fixé au bras de lancement (12) ; le modèle numérique (26) étant un modèle du lanceur et du bras de lancement ;
∘ et **en ce que** l'unité de calcul (22) est programmée pour :
- déterminer un vecteur d'état X_{l|v} du lanceur dans le repère virtuel (Rv), un vecteur d'état X_{b|v} du bras de lancement dans le repère virtuel (Rv), et la position P_{p|v} du projectile dans le repère virtuel (Rv) ;
- identification d'une phase d'armement (A), et le cas échéant, identification d'un tir du projectile et détermination des positions successives P_{p|v} du projectile dans le repère virtuel (Rv) à différents instants ;
- construire une image bidimensionnelle représentant l'environnement virtuel, une représentation numérique du lanceur et le projectile dans le repère virtuel (Rv) ;
- commander l'interface graphique pour afficher l'image construite.

## Patentansprüche

1. Verfahren zum Steuern einer grafischen Schnittstelle (2) zum Anzeigen von Bildern einer digitalen Darstellung (31) eines dreidimensionalen Gegenstands (10) in einer virtuellen Umgebung (Ev) und aufweisend eine Struktur (11) aus einem nicht magnetischen Material, wobei das Verfahren von einer Recheneinheit (22) durchgeführt wird und die folgenden Schritte aufweist:
∘ Bereitstellen einer Einrichtung zur Lokalisierung (20) des dreidimensionalen Gegenstands (10) in einem Nachverfolgungsbereich (Zs), aufweisend:
• ein Netz von Magnetometern, (Mᵢ) die auf einer Auflagefläche (Sa) befestigt sind,
• die Recheneinheit (22), die mit dem Netz von Magnetometern und der grafischen Schnittstelle verbunden ist,
• den Nachverfolgungsbereich (Zs) des dreidimensionalen Gegenstands (10) in Bezug auf das Netz von Magnetometern, der vordefiniert ist, und ein dreidimensionales, reales Koordinatensystem (Rr), das dem Nachverfolgungsbereich zugeordnet ist;
∘ Speichern (11, 12) in der Recheneinheit (22) von:
• einer digitalen Datei (25), die die virtuelle Umgebung (Ev) in einem virtuellen, dreidimensionalen Koordinatensystem (Rv) kodiert, wobei das virtuelle Koordinatensystem (Rv) dem realen Koordinatensystem (Rr) durch eine vordefinierte Entsprechungsbeziehung (F) zugeordnet ist;
• einem digitalen Modell (26), das es ermöglicht, einem Zustandsvektor X_{a|r} eines Magneten (15), der die Position und die Ausrichtung des Magneten im realen Koordinatensystem (Rr) darstellt, einen Zustandsvektor X_{b,v} des dreidimensionalen Gegenstands (10) im virtuellen Koordinatensystem (Rv) zuzuordnen, und es ermöglicht, eine digitale Darstellung (31) des dreidimensionalen Gegenstands (10) im virtuellen Koordinatensystem (Rv) zu erhalten;
∘ Handhaben (21), durch einen Benutzer, des dreidimensionalen Gegenstands (10), wobei sich dieser im Nachverfolgungsbereich befindet;
∘ Messen (22), eines von dem Magneten (15) erzeugten Magnetfelds zu verschiedenen aufeinanderfolgenden Messzeitpunkten tₙ durch das Netz von Magnetometern (Mᵢ);
∘ Bestimmen (23) des Zustandsvektors X_{a|r} des Magneten im realen Koordinatensystem (Rr) zum Messzeitpunkt tₙ aus den Messungen des vom Magneten erzeugten Magnetfelds;
∘ **dadurch gekennzeichnet, dass:** der dreidimensionale Gegenstand (10) als Abschussvorrichtung bezeichnet wird; die Abschussvorrichtung (10) zum Abschießen eines Projektils (32) in einer virtuellen Umgebung (Ev) geeignet ist; ein Abschussarm (12) beweglich und verschiebungsbeschränkt mit der Struktur (11) zusammengesetzt ist, wobei ein Magnet (15) an dem Abschussarm (12) befestigt ist; der Zustandsvektor X_{b|v} der des Abschussarms (12) der Abschussvorrichtung (10) ist und die Position und/oder die Ausrichtung des Abschussarms (12) darstellt;
∘ **dadurch, dass** der Benutzer bei dem Schritt der Handhabung (21) den Abschussarm (12) der Abschussvorrichtung (10) handhabt, wobei dieser zusätzlich in Kontakt mit der Auflagefläche angeordnet ist, wobei der Abschussarm (12) durch den Benutzer aus einer Ruheposition entfernt werden kann, wobei ein Rückstellorgan dann eine Rückstellkraft auf den Abschussarm in Richtung der Ruheposition ausübt;
∘ und **dadurch, dass** das Verfahren die folgenden Schritte aufweist:
∘ Bestimmen (24) zum Messzeitpunkt tₙ des Zustandsvektors X_{b|v} des Abschussarms (12) im virtuellen Koordinatensystem (Rv) anhand eines vorgespeicherten digitalen Modells (26) und des vorbestimmten Zustandsvektors X_{a|r} und der Position P_{p|v} des Projektils (32) anhand des vorgespeicherten digitalen Modells (26) und des vorbestimmten Zustandsvektors X_{b|v};
∘ Identifizieren (25) einer Rüstungsphase (A) des Abschussarms (12) in Abhängigkeit eines Rüstungsfaktors K1, der anhand des Zustandsvektors X_{b|v} zum Messzeitpunkt tₙ und zu früheren Messzeitpunkten definiert wird, wobei die Rüstungshase (A) identifiziert wird, wenn der Rüstungsfaktor K1 größer oder gleich einem vordefinierten Schwellenwert K1s ist;
∘ wenn die Rüstungsphase (A) identifiziert ist, Identifizieren (26) des Abfeuerns des Projektils (32) in Abhängigkeit von einem Abschussfaktor K2, der anhand des Zustandsvektors X_{b|v} zum Messzeitpunkt tₙ definiert wird, wobei das Abfeuern des Projektils (32) identifiziert wird, wenn der Abschussfaktor K2 größer oder gleich einem vordefinierten Schwellenwert K2s ist;
∘ wenn das Abfeuern des Projektils (32) identifiziert ist, Bestimmen (27) der aufeinanderfolgenden Positionen P_{p|v} des Projektils (32) im virtuellen Koordinatensystem (Rv) zu späteren Messzeitpunkten;
∘ Konstruieren (28) eines zweidimensionalen Bilds, das in dem virtuellen Koordinatensystem (Rv) anhand von dem vorbestimmten Zustandsvektor X_{b|v} des Abschussarms und der vorbestimmten Position P_{p|v} des Projektils die virtuelle Umgebung (Ev), die digitale Darstellung (31) der Abschussvorrichtung sowie das Projektil (32) darstellt, dann Steuern der grafischen Schnittstelle (2) durch die Recheneinheit (22) zum Anzeigen des konstruierten Bilds.

2. Steuerungsverfahren nach Anspruch 1, wobei:
∘ es das digitale Modell auch ermöglicht, dem Zustandsvektor X_{a|r} des Magneten (15) einen Zustandsvektor X_{l,v} der Abschussvorrichtung (10) zuzuordnen, der die Position und die Ausrichtung der Abschussvorrichtung im virtuellen Koordinatensystem (Rv) darstellt;
∘ der Benutzer bei dem Schritt des Handhabens (21) auch die Abschussvorrichtung (10) handhabt;
∘ bei dem Schritt des Bestimmens (24) des Zustandsvektors X_{b|v} des Abschussarms der Zustandsvektor X_{l,v} der Abschussvorrichtung (10) auch anhand des vorgespeicherten digitalen Modells (26) und des vorbestimmten Zustandsvektors X_{a|r} bestimmt wird;
∘ bei dem Schritt des Konstruierens (28) das zweidimensionale Bild die digitale Darstellung (31) der Abschussvorrichtung anhand des Zustandsvektors X_{l|v} der Abschussvorrichtung anzeigt.

3. Steuerungsverfahren nach Anspruch 1 oder 2, bei dem der Schritt des Bestimmens (27) der aufeinanderfolgenden Positionen P_{p|v} des Projektils (32) eine Identifikation eines Schnittpunktes zwischen einer der bestimmten aufeinanderfolgenden Positionen P_{p|v} und einer Fläche der virtuellen Umgebung (Ev), die einen Aufprall des Projektils (32) darstellt, und des Bestimmens einer Flugzeit zwischen dem Messzeitpunkt, zu dem das Abfeuern des Projektils identifiziert wird, und dem Messzeitpunkt, der dem Aufprall entspricht, aufweist.

4. Steuerungsverfahren nach Anspruch 3, bei dem während der Messzeitpunkte, die zu der Flugzeit gehören, die Schritte des Identifizierens (25) einer Rüstungsphase (A), des Identifizierens (26) des Abfeuerns des Projektils und des Bestimmens (27) der aufeinanderfolgenden Positionen P_{p|v} des Projektils nicht durchgeführt werden.

5. Steuerungsverfahren nach einem der Ansprüche 1 bis 4, wobei der Rüstungsfaktor K1 aus einem Neigungswinkel des Magneten (15), wenn der Abschussarm (12) schwenkbar mit der Struktur (11) zusammengesetzt ist, und/oder einer Position entlang einer Achse orthogonal zur Auflagefläche (Sa) und/oder einer Position entlang einer Ebene parallel zur Auflagefläche (Sa) definiert wird.

6. Steuerungsverfahren nach einem der Ansprüche 1 bis 5, bei dem die Rüstungsphase (A) für jeden aktuellen Messzeitpunkt tₙ nach einem Referenzmesszeitpunkt (t_{ref}) identifiziert wird, für den der Wurfarm einen Rüstungsfaktor K1(t_{ref}) gezeigt hat, der größer oder gleich dem vordefinierten Schwellenwert K1s ist, wobei der Abschussarm zu dem aktuellen Messzeitpunkt tₙ von der Ruheposition entfernt ist.

7. Steuerungsverfahren nach einem der Ansprüche 1 bis 6, bei dem, wenn die Rüstungsphase (A) identifiziert ist, eine geschätzte Strecke (Ť_{p|v}) des Projektils im virtuellen Koordinatensystem Rv auf der Grundlage des Zustandsvektors X_{l|v} der Abschussvorrichtung und des Zustandsvektors X_{b|v} des Abschussarms bestimmt wird, und eine digitale Darstellung der geschätzten Strecke (Ť_{p|v}) auf dem Bild angezeigt wird, das bei dem Schritt (28) des Steuerns der grafischen Schnittstelle (2) konstruiert wurde.

8. Steuerungsverfahren nach einem der Ansprüche 1 bis 7, wobei das Abfeuern des Projektils zu einem Messzeitpunkt identifiziert wird, zu dem der Abschussarm seine Ruheposition erreicht, wobei die Rüstungsphase (A) mit mindestens dem vorherigen Messzeitpunkt identifiziert wird.

9. Steuerungsverfahren nach einem der Ansprüche 1 bis 8, wobei der Abschussfaktor K2 aus einer Durchschnittsgeschwindigkeit und/oder einer Momentangeschwindigkeit des Abschussarms zu mindestens dem Messzeitpunkt, zu dem er seine Ruheposition erreicht, definiert wird.

10. Steuerungsverfahren nach einem der Ansprüche 1 bis 9, wobei der Zustandsvektor X_{a|r} des Magneten durch einen Bayes'schen Schätzungsalgorithmus oder durch eine Optimierungsmethode bestimmt wird.

11. Steuerungsverfahren nach einem der Ansprüche 1 bis 10, wobei die virtuelle Umgebung (Ev) ein dreidimensionaler Raum ist, dessen Abmessungen größer als die des Nachverfolgungsbereichs (Zs) sind.

12. Informationsspeichermedium, das Anweisungen zum Ausführen eines Steuerungsverfahrens nach einem der vorstehenden Ansprüche aufweist, wenn diese Anweisungen von einer elektronischen Recheneinheit ausgeführt werden.

13. Steuerungsapparat (1) für eine grafische Schnittstelle (2) zum Anzeigen von Bildern einer digitalen Darstellung (31) eines dreidimensionalen Gegenstands (10) in einer virtuellen Umgebung (Ev), aufweisend:
∘ einen dreidimensionalen Gegenstand (10), der eine Struktur (11) aus einem nichtmagnetischen Material aufweist, die zusammengesetzt ist mit
∘ einer grafischen Schnittstelle (2);
∘ einer Einrichtung zur Lokalisierung (20), aufweisend:
• ein Netz von Magnetometern, (Mᵢ) die auf einer Auflagefläche (Sa) befestigt sind;
• eine Recheneinheit (22), aufweisend einen Speicher (24), in dem eine digitale Datei (25), die die virtuelle Umgebung in einem virtuellen Koordinatensystem (Rv) kodiert, sowie ein digitales Modell (26) des dreidimensionalen Gegenstands (10) gespeichert sind, wobei die Recheneinheit programmiert ist zum:
- Erfassen von Messungen des von dem Magneten erzeugten Magnetfelds;
- Berechnen eines Zustandsvektors X_{a|r} des Magneten in einem realen Koordinatensystem (Rr), das einem Nachverfolgungsbereich (Zs) zugeordnet ist, der in Bezug auf die Auflagefläche (Sa) definiert ist;
∘ **dadurch gekennzeichnet, dass:** der dreidimensionale Gegenstand (10) als Abschussvorrichtung bezeichnet wird; der Steuerungsapparat (1) zur Durchführung des Steuerungsverfahrens nach einem der Ansprüche 1 bis 11 geeignet ist; ein Abschussarm (12) beweglich und verschiebungsbeschränkt mit der Struktur (11) zusammengesetzt ist, wobei ein Magnet (15) an dem Abschussarm (12) befestigt ist; das digitale Modell (26) ein Modell der Abschussvorrichtung und des Abschussarms ist;
∘ und **dadurch, dass** die Recheneinheit (22) so programmiert ist zum:
- Bestimmen eines Zustandsvektors X_{l|v} der Abschussvorrichtung in dem virtuellen Koordinatensystem (Rv), eines Zustandsvektors X_{b|v} des Abschussarms in dem virtuellen Koordinatensystem (Rv) und der Position P_{p|v} des Projektils in dem virtuellen Koordinatensystem (Rv);
- Identifizieren einer Rüstungsphase (A) und gegebenenfalls Identifizieren eines Abfeuern des Projektils und Bestimmen der aufeinanderfolgenden Positionen P_{p|v} des Projektils im virtuellen Koordinatensystem (Rv) zu verschiedenen Zeitpunkten;
- Konstruieren eines zweidimensionalen Bilds, das die virtuelle Umgebung, eine digitale Darstellung der Abschussvorrichtung und das Projektil in dem virtuellen Koordinatensystem (Rv) darstellt;
- Steuern der grafischen Schnittstelle zum Anzeigen des konstruierten Bilds.

## Claims

1. A method for controlling a graphical interface (2) for displaying images of a digital representation (31) of a three-dimensional object (10), in a virtual environment (Ev), and comprising a structure (11) made of a non-magnetic material, the method being implemented by a computing unit (22), comprising the following steps:
∘ providing a device (20) for locating the three-dimensional object (10) in a tracking area (Zs), comprising:
• a network of magnetometers (Mᵢ) attached to a bearing surface (Sa),
• the computing unit (22) being connected to the network of magnetometers and the graphical interface,
• the tracking area (Zs) of the three-dimensional object (10) relative to the network of magnetometers being predefined, and a three-dimensional coordinate system called real (Rr) being associated with the tracking area;
∘ recording (11, 12) in the computing unit (22):
• a digital file (25) encoding the virtual environment (Ev) in a three-dimensional coordinate system called virtual (Rv), the virtual coordinate system (Rv) being associated with the real coordinate system (Rr) by a predefined correspondence relationship (F);
• a digital model (26) for associating, with an X_{a|r} state vector of a magnet (15) representative of the position and orientation of the magnet in the real coordinate system (Rr), a state vector X_{b,v} of the three-dimensional object (10) in the virtual coordinate system (Rv), and making it possible to obtain a digital representation (31) of the three-dimensional object (10) in the virtual coordinate system (Rv);
∘ manipulating (21), by a user, the three-dimensional object (10), said object being located in the tracking area;
∘ measuring (22), by the network of magnetometers (Mᵢ), a magnetic field generated by the magnet (15) at different measurement successive times tₙ;
∘ determining (23) the state vector X_{a|r} of the magnet in the real coordinate system (Rr), at the measurement time tₙ, from the measurements of the magnetic field generated by the magnet;
∘ **characterized in that:** the three-dimensional object (10) is called a launcher; the launcher (10) is adapted to launch a projectile (32) in a virtual environment (Ev); a launching arm (12) is assembled to the structure (11) in a movable manner and constrained when moving, a magnet (15) being attached to the launching arm (12); the state vector X_{b|v} is that of the launch arm (12) of the launcher (10) and is representative of the position and/or orientation of the launch arm (12);
∘ **in that,** in the manipulating step (21), the user manipulates the launch arm (12) of the launcher (10), said launcher further being arranged in contact with the bearing surface, the launching arm (12) being capable of being moved away from a rest position by the user, a return member then exerting a return force on the launching arm toward the rest position;
∘ and **in that** the method comprises the following steps:
∘ determining (24), at the measurement time tₙ, the state vector X_{b|v} of the launching arm (12) in the virtual coordinate system (Rv), from the pre-recorded digital model (26) and from the predetermined state vector X_{a|r}, as well as from the position P_{p|v} of the projectile (32) from the pre-recorded digital model (26) and the predetermined state vector X_{b|v};
∘ identifying (25) an arming phase (A) for the launch arm (12), as a function of an arming factor K1 defined from the state vector X_{blv} at the measurement time tₙ and at previous measurement times, the arming phase (A) being identified when the arming factor K1 is greater than or equal to a predefined threshold value K1s;
∘ when the arming phase (A) is identified, identifying (26) the firing of the projectile (32) as a function of a launch factor K2 defined from the state vector X_{blv} at the measurement time tₙ wherein the firing of the projectile (32) is identified when the launch factor K2 is greater than or equal to a predefined threshold value K2s;
∘ when the firing of the projectile (32) is identified, determining (27) the successive positions P_{p|v} of the projectile (32) in the virtual coordinate system (Rv) at subsequent measurement times;
∘ constructing (28) a two-dimensional image, representing in the virtual coordinate system (Rv) the virtual environment (Ev), the digital representation (31) of the launcher, as well as the projectile (32), from the predetermined state vector X_{blv} of the launching arm and position Pₚₗᵥ of the projectile, then controlling the graphical interface (2) by the computing unit (22) to display the constructed image.

2. The control method according to claim 1, wherein:
∘ the digital model also makes it possible to associate, with the state vector X_{a|r} of the magnet (15), a state vector X_{l,v} of the launcher (10) representative of the position and orientation of the launch vehicle in the virtual coordinate system (Rv);
∘ during the manipulating step (21), the user also manipulates the launcher (10);
∘ during the step (24) of determining the state vector X_{b|v} of the launch arm, the state vector X_{l,v} of the launcher (10) is also determined from the pre-recorded digital model (26) and from the predetermined state vector X_{a|r};
∘ during the constructing step (28), the two-dimensional image displays the digital representation (31) of the launcher from the state vector X_{l|v} of the launcher.

3. The control method according to claim 1 or 2, wherein the step (27) of determining the successive positions P_{p|v} of the projectile (32) comprises identifying an intersection between one of the determined successive positions P_{p|v} and a surface of the virtual environment (Ev) representative of an impact of the projectile (32), and determining a time of flight between the measurement time at which the firing of the projectile has been identified and the measurement time corresponding to said impact.

4. The control method according to claim 3, wherein, during the measurement times belonging to said flight time, the steps of identifying (25) an arming phase (A), of identifying (26) the firing of the projectile, and of determining (27) the successive position P_{p|v} of the projectile, are not performed.

5. The control method according to any one of claims 1 to 4, wherein the arming factor K1 is defined from an angle of inclination of the magnet (15) when the launching arm (12) is assembled by pivot connection on the structure (11) and/or from a position along an axis orthogonal to the bearing surface (Sa), and/or from a position along a plane parallel to the bearing surface (Sa).

6. The control method according to any one of claims 1 to 5, wherein the arming phase (A) is identified for any measurement time referred to as current tₙ that is subsequent to a reference measurement time (t_{ref}) for which the launching arm has an arming factor K1 (t_{ref}) greater than or equal to the predefined threshold value K1s, the launching arm at the current measurement time tₙ being away from the rest position.

7. The control method according to any one of claims 1 to 6, wherein, when the arming phase (A) is identified, an estimated trajectory (Ť_{p|v}) of the projectile in the virtual coordinate system Rv is determined on the basis of the state vector X_{l|v} of the launcher and the state vector X_{b|v} the launching arm, and a digital representation of the estimated trajectory (Ť_{p|v}) is displayed on the image constructed during the step (28) of controlling the graphical interface (2).

8. The control method according to any one of claims 1 to 7, wherein the firing of the projectile is identified at a measurement time for which the launching arm has reached its rest position, the arming phase (A) being identified at least at the preceding measurement time.

9. The control method according to any one of claims 1 to 8, wherein the launch factor K2 is defined from an average speed and/or an instantaneous speed of the launch arm at least at the measurement moment for which it has reached its rest position.

10. The control method according to any one of claims 1 to 9, wherein the state vector X_{a|r} of the magnet is determined by a Bayesian estimation algorithm or by an optimization method.

11. The control method according to any one of claims 1 to 10, wherein the virtual environment (Ev) is a three-dimensional space of dimensions greater than those of the tracking area (Zs).

12. An information recording medium, comprising instructions for executing a control method according to any one of the preceding claims, when these instructions are executed by an electronic computing unit.

13. A control apparatus (1) for a graphical interface (2) for displaying images of a digital representation (31) of a three-dimensional object (10), in a virtual environment (Ev), comprising:
∘ a three-dimensional object (10) comprising a structure (11) made of a non-magnetic material to which is assembled
∘ a graphical interface (2);
∘ a locating device (20), comprising:
• a network of magnetometers (Mᵢ) attached to a bearing surface (Sa);
• a computing unit (22) comprising a memory (24) in which is recorded a digital file (25) encoding the virtual environment in a virtual coordinate system (Rv), as well as a digital model (26) of the three-dimensional object (10), the computing unit being programmed to:
- acquire measurements of the magnetic field generated by the magnet;
- calculating a state vector X_{a|r} of the magnet in a real coordinate system (Rr) associated with a tracking area (Zs) defined relative to the bearing surface (Sa);
∘ **characterized in that:** the three-dimensional object (10) is called a launcher; the control apparatus (1) is adapted to implement the control method according to any one of claims 1 to 11; a launching arm (12) is assembled to the structure (11) in a movable manner and constrained when moving, a magnet (15) being attached to the launching arm (12); the digital model (26) being a model of the launcher and the launch arm;
∘ and **in that** the computing unit (22) is programmed to:
- determine a state vector X_{l|v} of the launcher in the virtual coordinate system (Rv), a state vector X_{blv} of the launching arm in the virtual coordinate system (Rv), and the position Pₚₗᵥ of the projectile in the virtual coordinate system (Rv);
- identify an arming phase (A), and if applicable, identify a firing of the projectile and determining the successive positions P_{p|v} of the projectile in the virtual coordinate system (Rv) at different times;
- construct a two-dimensional image representing the virtual environment, a digital representation of the launcher and the projectile in the virtual coordinate system (Rv);
- control the graphical interface to display the constructed image.
